# EUROPEAN PATENT APPLICATION

(11) **EP 0 805 528 A2**
(43) Date of publication of application: **05.11.1997**
(21) Application number: 97106560.2
(22) Date of filing: 21.04.1997
(51) Int. Cl.: H01S 3/085, H01S 3/025

(54) **Reflection power monitoring system for vertical cavity surface emitting lasers**

(30) Priority: 29.04.1996 US 639462
(71) Applicant: MOTOROLA, INC., Schaumburg, IL 60196 (US)
(72) Inventor: Jiang, Wenbin, Phoenix, Arizona 85044 (US); Lebby, Michael S., Apache Junction, Arizona 85219 (US)
(74) Representative: Gibson, Sarah Jane

(57) **Abstract**

A power monitoring system (60) including a vertical cavity surface emitting laser (10) generating an emission along a path. An optical element (68, 82) is positioned in the path to reflect a portion of the emission. A monitor (50) is positioned to receive the reflected portion of the emission. An output (57) of the monitor (50) is used to control emissions (90, 92, 94) of the vertical cavity surface emitting laser (10).

## Description

### Field of the Invention

The present invention pertains to vertical cavity surface emitting lasers.

More particularly, the present invention pertains to power monitoring of vertical cavity surface emitting lasers.

Further and more specifically, the present invention pertains to auto power controlled vertical cavity surface emitting lasers.

### Background of the Invention

Since the development of laser diodes, many applications for their use have been developed. Increasingly, laser diodes are employed for communications and are integral to optical disc recording and storage systems. Typically, edge emitting diode lasers are used. Edge emitting diode lasers, however, have a high cost in parallel and serial data links, and have a high current drain due to a high threshold current when used in compact disc pickups.

New systems are being developed to employ vertical cavity surface emitting lasers (VCSEL) in place of edge emitting lasers. The VCSELs provide a much lower cost, use surface emissions which simplify optical devices and are capable of being fabricated in larger volumes on semiconductor wafers. However, during use, temperature fluctuations and degradation of the VCSEL device cause fluctuations in the emissions. These fluctuations cause errors in data retrieval and furthermore the threshold level may increase, thereby requiring more power input to sustain lasing. Edge emitting laser diodes employ a power monitoring detector facing the back emission facet of the device. In a VCSEL, there are no back emissions due to the construction of the mirror stacks and the opaque substrate on which the device is necessarily formed.

It would be highly advantageous, therefore, to remedy the foregoing and other deficiencies inherent in the prior art.

Therefore it is desirable that a system be developed for monitoring the emissions of a VCSEL.

Accordingly, it is an object of the present invention to provide a power monitoring system for a VCSEL.

Another object of the present invention is to provide a power monitoring system which will automatic control the emissions.

And another object of the present invention is to provide an inexpensive and easily fabricated power monitor system and automatic power control.

### Summary of the Invention

Briefly, to achieve the desired objects of the instant invention, in accordance with a preferred embodiment thereof, provided is a power monitoring system including a vertical cavity surface emitting laser generating an emission along a path. An optical element positioned in the path and reflecting a portion of the emission. A monitor optically positioned to receive the reflected portion of the emission.

In accordance with a further embodiment of the invention, a method of forming a power monitoring system is provided, including the steps of providing a vertical cavity surface emitting laser for generating an emission along a path. Positioning an optical element in the path for reflecting a portion of the emission. Positioning a monitor to receive the reflected portion of the emission.

In accordance with yet another embodiment of the invention, a method of monitoring emissions from vertical cavity surface emitting lasers is provided, including the steps of providing a vertical cavity surface emitting laser. Generating an emission from the vertical cavity surface emitting laser along a path. Reflecting a portion of the emission, and receiving the reflected portion of the emission by a monitor.

### Brief Description of the Drawings

The foregoing and further and more specific objects and advantages of the instant invention will become readily apparent to those skilled in the art from the following detailed description of preferred embodiments thereof taken in conjunction with the drawings in which:
FIG. 1 is a simplified cross-sectional view of a vertical cavity surface emitting laser;
FIG. 2 is a simplified cross-sectional view of a photodiode;
FIG. 3 is a simplified isometric view of a power monitoring system in accordance with the present invention;
FIG. 4 is a simplified partial side sectional view of another embodiment of a power monitoring system in accordance with the present; and
FIG. 5 is a block diagram of the power monitoring system including an automatic power control device.

### Detailed Description of the Preferred Embodiment

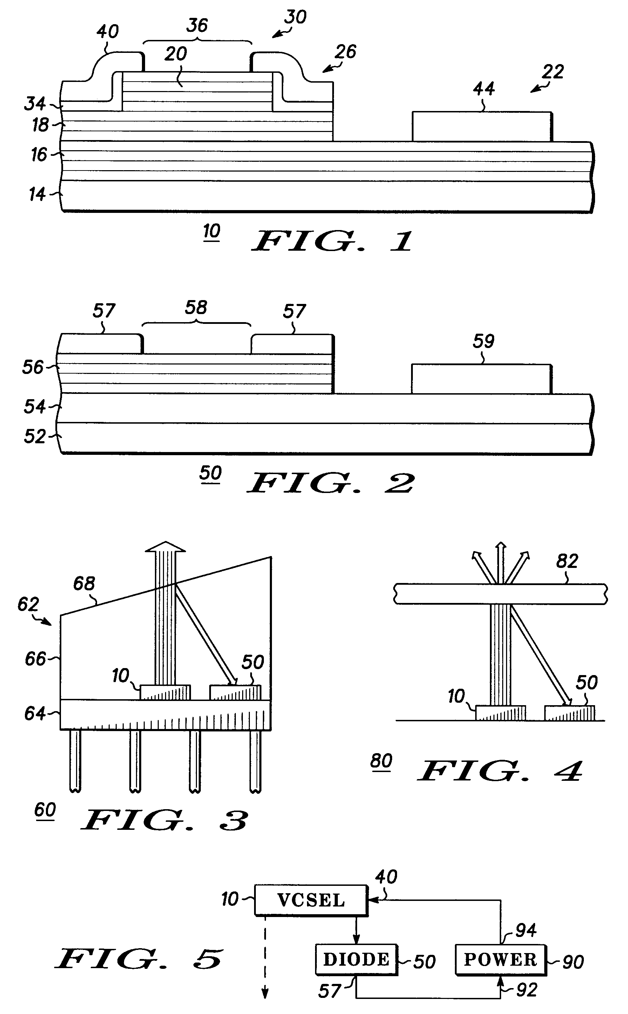

Turning now to the drawings in which like reference characters indicate corresponding elements throughout the several views, attention is first directed to FIG. 1 which illustrates a vertical cavity surface emitting laser (VCSEL) generally designated 10 and formed on a substrate 14. The specific VCSEL illustrated is being utilized for purposes of this disclosure only and can be any of a wide variety of different types of VCSELs including ridge, planar, those etched completely through the structure, etc. In this embodiment VCSEL 10 is fabricated by epitaxially growing a first mirror stack 16 on the top surface of substrate 14. Mirror stack 16 includes a plurality of layers of semiconductor material with alternating indexes of refraction. Some examples of materials that can be used for this purpose are: alternating layers of Al0.15Ga0.85As and Al0.80Ga0.20As; alternating layers of GaAs and Al0.80Ga0.20As; etc. Each pair of alternating layers are grown to an optical thickness of one quarter of the emission wavelength, propagating in the layers, and the number of pairs is chosen to provide as much reflectivity of light as possible while limiting the stack to a practical number. An active region 18 is grown on the upper surface of mirror stack 16, which includes one or more quantum wells separated by barrier layers with a spacer and/or cladding layer on either side thereof. The quantum wells and spacer layers are also grown epitaxially.

A second mirror stack 20 is formed on the upper surface of active region 18 by, for example, epitaxially growing pairs of semiconductor layers as described in conjunction with mirror stack 16. Generally, the pairs of layers will be formed of materials similar to those of mirror stack 16 and the thicknesses will be similar to provide the proper reflectivity of a selected wavelength or spectrum of wavelengths. Also, first and second mirror stacks 16 and 20 are doped with opposite conductivity types to form a two terminal (diode) structure for the flow of electrical current therethrough.

VCSEL 10 is defined by etching a trench 22 through second mirror stack 20 and active region 18 to separate VCSEL 10 and 12 and to define an outer boundary thereof. Trench 22 exposes an upper surface of first mirror stack 16 so that an electrical contact can be made to mirror stack 16. VCSEL 10 is further defined by patterning the structure as follows. The upper surface of mirror stack 20 is provided with a layer of photoresist alone or in combination with oxynitride material in any of the well known methods. The photo resist layer is exposed and material is removed to define the position and size of a trench 26. Trench 26 is then formed by etching mirror stack 20 by any convenient means such as, ion milling, dry etching, wet etching, etc. In general, trench 26 extends completely around and defines an operating area, or mesa 30 for VCSEL 10. Generally operating area, or mesa 30 has a circular cross-section.

In this specific embodiment trench 26 extends into mirror stack 20 from the upper surface thereof, approximately to the active region 18. While this depth is convenient for current limiting and etching techniques, it is only necessary that trench 26 be sufficiently deep to reduce reflectivity of mirror stack 20 in the volume between the bottom of trench 26 and active layer 18 so that a non-lasing volume is produced beneath trench 26. The non-lasing volume surrounds a lasing volume below mesa 30, which lasing volume is substantially coaxial with mesa 30. In at least some applications lasing will not be supported when the reflectivity is reduced to less than approximately 98%. A complete disclosure of the construction of ridge VCSELs is available in U.S. Patent No. 5,256,596 entitled "Top Emitting VCSEL with Implant", issued 26 October 1993 and assigned to the same assignee.

A dielectric layer 34 is formed on the surface of mesa 30. Dielectric layer 34 is patterned to define an emission window 36 for VCSEL 10. Also, a portion of the upper surface of mirror stack 16 adjacent mesa 30 is exposed. A first contact 40 for VCSEL 10 is formed on mesa 30 in contact with upper mirror stack 20. A second contact 44 for VCSEL 10 is formed on the upper surface of mirror stack 16 adjacent mesa 30 but could be formed on the reverse or bottom side of substrate 14, whichever is more convenient.

The quantum wells of active regions 18 in VCSEL 10 produce photons (light) in accordance with a well known phenomenon when properly energized by electrical current applied thereacross. In general, the greater the current applied to active region 18, the greater the number of photons generated. The photons are reflected by mirror stack 16 and 20 in VCSELs 10 to produce the well known lasing effect that ultimately produces the emitted light.

Turning now to FIG. 2, a photodiode generally designated 50 is illustrated. Again, the specific photodiode being illustrated is utilized for purposes of this explanation only and may be any convenient photo sensitive device. Photodiode 50 includes a second substrate 52 on which a mirror stack 54 is epitaxially grown. An active region 56 is epitaxially formed on the upper surface of mirror stack 54. A portion of active region 56 is etched to expose a surface of mirror stack 54. A first electrical contact 57 is formed on the surface of active region 56 defining a light receiving window 58, and a second electrical contact 59 is formed on the exposed surface of mirror stack 54. It will of course be understood that contact 59 could be formed on the reverse or lower surface of substrate 52, if that is more convenient. It should be understood that while a mirror stack can be utilized to improved the efficiency of photodiode 50, in many instances only an active region and cladding layers may be employed. Further, the photodiode, or photo sensitive device, being utilized has a specific sensitivity which generally must be supplied to produce an output signal.

Referring now to FIG. 3, a power monitoring system generally designated 60 is illustrated. Photodiode 50 acts as a monitoring device to monitor the emissions from VCSEL 10. This is accomplished by positioning photodiode 50 to receive a portion of the emissions reflected from an optical element. The optical element permits the majority of the emissions to pass through for further use, while reflecting a small percentage back to photodiode 50. Generally, the small percentage is approximately equal to, or greater than, the sensitivity of the photo sensitive device (photodiode 50). In the preferred embodiment, system 60 includes a TO package 62 having a base 64, a cover 66 enclosing the upper surface of base 64, and a cover window 68 carried by cover 66 in an opposing relationship with base 64. It is cover window 68 which operates as the optical element, reflecting a portion of the emissions. VCSEL 10 and photodiode 50 are mounted on the upper surface of base 64 and are enclosed by cover 66. Cover window 68 is tilted at a degree of angle with respect to emissions from VCSEL 10 and the upper surface of base 64. With an angle of 10 degrees or more, and without AR coating on cover window 68, approximately 4 percent of the emission will be reflected back towards base 64. Photodiode 50 is mounted adjacent VCSEL 10 to receive the reflected light. It will be understood that while a TO type package is illustrated in the preferred embodiment, other packages and optical elements may be employed.

Turning now to FIG. 4, another embodiment of a power monitoring system generally designated 80 is illustrated. In this embodiment, the optical element is a holographic optical element 82 (HOE). HOE are used to divide and shape emissions from VCSELs. HOE 82 employs a transmission grating 84 to divide the emission into three beams for three-beam-spot detection. One of the two reflected diffraction beams from transmission grating 84 is received by photodiode 50 positioned adjacent VCSEL 10. One skilled in the art will understand that many different types of packaging may be employed to carry VCSEL 10, photodiode 50 and HOE 82.

Referring specifically to FIG. 5, power monitoring systems 60 or 80 can also include a power control device 90 having a control input 92 and a power output 94. Control input 92 is coupled to contact 57 of photodiode 50, and power output 94 is coupled to contact 40 of VCSEL 10. In operation, a reflected portion of the emissions from VCSEL 10 are monitored by photodiode 50 to develop a control signal which is utilized to control power to VCSEL 10 through power control device 90. Since the reflected portion of the emissions from VCSEL 10 received by photodiode 50 is proportional to the portion passing through the optical element, the reflected portion monitored by photodiode 50 can establish the characteristics of the emissions from VCSEL 10.

Thus a system for monitoring the emissions of a VCSEL utilizing a power monitor has been disclosed. Further disclosed is a power monitoring system which will automatically control the emissions of the VCSEL. The power monitor system and automatic power control is inexpensive and easily fabricated.

Various modifications and changes to the embodiments herein chosen for purposes of illustration will readily occur to those skilled in the art. The foregoing is given by way of example only. Other modifications and variations may be made by those skilled in the art without departing from the scope of the invention as defined by the following claims.

Having fully described and disclosed the present invention and preferred embodiments thereof in such clear and concise terms as to enable those skilled in the art to understand and practice same, the invention claimed is:

## Claims

1. A power monitoring system characterized by:
a vertical cavity surface emitting laser (10) generating an emission along a path;
an optical element (68, 82) positioned in the path and reflecting a portion of the emission; and
a monitor (50) optically positioned to receive the reflected portion of the emission.

2. A power monitoring system as claimed in claim 1 wherein the vertical cavity surface emitting laser (10) is further characterized by being carried by a TO package (62) and the optical element is a cover window (68) of the TO package (62) tilted at a degree of angle with respect to the emission.

3. A power monitoring system as claimed in claim 1 wherein the optical element is further characterized by being a holographic optical element (82) having a transmission grating for splitting the emission.

4. A power monitoring system as claimed in claim 1 wherein the monitor (50) is a photodiode (50).

5. A power monitoring system as claimed in claim 4 wherein the photodiode (50) is carried adjacent the vertical cavity surface emitting laser (10).

6. A power monitoring system as claimed in claim 1 further including a power control device (90) having a control input (92) and a power output (94), the control input (92) coupled to an output terminal (57) of the monitor (50) and the power output (94) coupled to the vertical cavity surface emitting laser (10).

7. A power monitoring system as claimed in claim 1 wherein the monitor (50) has a sensitivity and the optical element (68, 82) positioned in the path is designed so that the portion of the emission reflected is greater than the sensitivity of the monitor (50).

8. A method of monitoring emissions from vertical cavity surface emitting lasers comprising the steps of:
providing a vertical cavity surface emitting laser (10);
generating an emission from the vertical cavity surface emitting laser (10) along a path;
reflecting (68, 82) a portion of the emission; and
receiving (50) the reflected portion of the emission by a monitor.

9. A method as claimed in claim 8 wherein the step of reflecting a portion of the emission includes providing a TO package (62) carrying the vertical cavity surface emitting laser (10), and including a cover window (68) of the TO package (62) tilted at a degree of angle with respect to the emission.

10. A method as claimed in claim 8 wherein the step of reflecting a portion of the emission includes providing a holographic optical element (82) having a transmission grating for splitting the emission.
